(19) Europäisches Patentamt / European Patent Office / Office européen des brevets

(11) **EP 1 995 604 B1**

(12) **EUROPEAN PATENT SPECIFICATION**

(45) Date of publication and mention
of the grant of the patent:
**04.11.2009 Bulletin 2009/45**

(51) Int Cl.:
***G01R 33/561*** *(2006.01)*

(21) Application number: **07075385.0**

(22) Date of filing: **21.05.2007**

(54) **High speed, high resolution, silent, real-time MRI method**

Schnelles, geräuscharmes Echtzeitverfahren der bildgebenden magnetischen Resonanz mit hoher Auflösung

Méthode rapide et silencieuse d'IRM à haute résolution en temps réel

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**26.11.2008 Bulletin 2008/48**

(73) Proprietors:
- **Emid, Soemar**
  **2718 AX Zoetermeer (NL)**
- **Emid-Danoesastro, Annie**
  **2718 AX Zoetermeer (NL)**
- **Hartini Emid, Joyce**
  **2718 AX Zoetermeer (NL)**
- **Emid, Alain S.R.**
  **46190 Riba-Roja (ES)**

(72) Inventor: **Emid, Soemar**
**2718 AX Zoetermeer (NL)**

(56) References cited:
EP-A2- 0 256 779    WO-A-98/12964
GB-A- 2 102 577    US-A- 4 727 325
US-A- 4 728 892

- **CORY D G: "NEW APPROACHES TO NMR IMAGING IN A ROTATING FIELD GRADIENT" JOURNAL OF MAGNETIC RESONANCE, ACADEMIC PRESS, ORLANDO, FL, US, vol. 82, no. 2, 1 April 1989 (1989-04-01), pages 337-341, XP000008794 ISSN: 1090-7807**
- **I.SHENBERG ET AL.: "A Direct MRI Hankel Transform System Using Rotating Gradients" IEEE TRANS.MED.IMAG., vol. MI-5, 1986, pages 121-127, XP009086493**
- **OHNO K ET AL: "ELECTRON PARAMAGNETIC RESONANCE IMAGING USING MAGNETIC-FIELD-GRADIENT SPINNING" JOURNAL OF MAGNETIC RESONANCE, ACADEMIC PRESS, ORLANDO, FL, US, vol. 143, no. 2, April 2000 (2000-04), pages 274-279, XP000924110 ISSN: 1090-7807**
- **R.R.ERNST ET AL.: "Principles of Nuclear Magnetic Resonance in One and Two Dimensions" 1991, CLARENDON PRESS , OXFORD , XP002441987 see chapter '4.1.3.2 Resolution enhancement'**

**EP 1 995 604 B1**

**Description**

Problems to be solved. The present invention relates to the field of non-invasive MRI (magnetic resonance imaging), in particular high speed, high resolution, silent, real-time imaging, in NMR (nuclear magnetic resonance) as well as ESR (electron spin resonance), of solids, liquids and gases. It is especially designed to solve the acoustic noise problem, the changing EMF (electromagnetic field) radiation problem, the long stay in high field problem and low throughput, the SAR (specific absorption rate) issue and many more aspects of present state of the art MRI, not only in the variety of clinical applications (diagnostics, interventional, functional research: fMRI, especially brain functions, real-time cine MRI, like cardiac MRI), but in research, especially biomolecular research, and industrial applications as well. In MRM (magnetic resonance microscopy) especially in solids (teeth, cartilage), high resolution capability is required. This is necessary to study osteoarthritis cartilage, a chronic progressive joint disease in the ageing population of the industrialized world. The mentioned problems are solved with the present invention having the mentioned characteristics.

Backgrounds. The MRI technique has been applied for more than three decade in many fields of activities, with benefits, but also with problems. Although in the beginning MRI started in principle [1] from the usual NMR apparatus configuration for spectroscopy, by addition of a static magnetic field gradient for spatial encoding, at present almost all practical high speed methods apply time-variable magnetic field gradients for the spatial encoding, in the phase encoding and/or in the readout direction. There are numerous state of the art imaging methods. The fastest method, EPI (echo planar imaging) [2], has comparatively the highest acoustic SPL (sound pressure level), apart from many problems with artifacts. MRI has big impact in many fields, especially in healthcare, but there are urgent problems to be solved. Namely, the changing currents generating the field gradients to change rapidly in time interact with the main magnetic field according to the Maxwell equations of electrodynamics. The changing Lorentz force, proportional to the main field strength, causes vibrations of the gradient coils, with amplitudes proportional to the main field strength, including normal mode excitations, i.e. provoking acoustic resonances) of the gradient coils giving the acoustic noise, which increases with increasing main field [3,4], and can be 120 dB or more, comparable to a jetliner on take off nearby (pain level is 140 dB), which is much higher than 80 dB, comparable to a running truck engine, which is considered already as annoying, especially for the ill. The acoustic noise causes discomfort and anxiety to the patients, during the clinical scan, which last for half an hour or more. The acoustic noise is also troublesome in functional MRI as it interacts with the object to be imaged and causes changes in the functions to be studied. The mentioned interaction causes also changing EMF radiation with the potential hazard of provoking cellular resonances (with unknown normal modes) on attending personnel helping to comfort the patients. The level of the radiation is too high according to the EU (European Union) physical agents Directive 2004/40/EC radiation level norm, effective 30 April 2008. The consequence would be that per year more than 400.000 patients in the EU territory will remain untreated with MRI. The situation is worsened as reports of measurements of the effects of EMF radiation showed uncertainties as revealed during the world conference on EMF radiation, February 2007, Milan, Italy. This means that no firm scientific grounds are available as a basis for conclusion and decision, apart from the uncertainties one is left with regarding the healthcare. The Alliance for MRI was launched in March 2007, supported by the European Society of Radiology, many leading Members of the European Parliament, many European and national patient groups and representative medical groups, expressing their concerns, arguing against the application of the Directive 2004/40/EC. This situation, with conflicting interests, is unsatisfactory and one is filled with mixed feelings about EMF radiation problem in general as adverse effects are known from power lines and mobile phones antennas, but also from patients and attending staff, suffering from nausea, dizziness and metal taste associated with MRI scans. The acoustic noise causes many problems in fMRI, preventing many patients to be treated, as reported in the literature. Therefore the best for all would be to solve the whole EMF radiation problem and to make the imaging session as brief as possible in clinical scans. The coil vibrations cause contraction, expansion as well as bending of the gradient assembly, which will result in variation of the field gradient and this in turn affect the accuracy of the results. The present invention is a magnetic resonance imaging technique which solves the above mentioned problems.

Prior arts. A brief review is first given of classifications of the state of the arts: 1. MRI imaging modalities using time varying field gradient strengths for encoding and/or readout. 2. MRI imaging modalities using k-space formalism with subsequent transformation to real space to end up with the image. 3. MRI imaging modalities with constant field gradient strengths for encoding or readout. 4. MRI-related modalities of the general kind. These classifications served as a guide for search and examination of the literature of the art.

Group 1. As the invention is to solve the acoustic noise problem and the EMF radiation problem, constant field gradient strength will be used for encoding, so all the methods using time varying field gradient strengths are not considered as option and therefore as not opposing to the invention.

Group 2. As the invention is addressed to high resolution imaging, from the fundamental point of view, it is not inventive to follow the k-space procedure as done in this group of present day art. This is even worse, if not impossible, for high resolution in the case of solids. So the description will be in real space-time as where the image is. Therefore, all the modem MRI methods using k-space formalism are not considered as opposing for the invention.

Group 3. MRI imaging with constant field gradient strength. Lauterbur [1] started present day art of imaging with constant gradient strength, by rotating the gradient about the object by way of demonstration, obtaining the image by projection reconstruction. Cho et. al. [5,6] proposed a DC gradient rotated mechanically around the object, similar to [1], in an attempt for silent MRI. However, such a method is considered impractical and a potential safety hazard, see [7], where other rules are proposed for some silent sequences with changing gradient strength, but unsatisfactory for EPI. This will be solved in this invention.

Group 4. No references are given for imaging modalities in the general sense, which have no particular relation with the invention.

Acquisition of MRI data along a plurality of concentric (half-)circular trajectories in K-space is known, for instance, from US-A-4 727 825 and JMR 82 (1989) 337-341. EP-A-0 256 779 discloses the acquisition of data along a constant velocity spiral trajectory in k-space. In the technique disclosed in IEEE Trans. Med. Imag. MI-5 (1986) 121-127 quadrature sinusoidal gradients having a uniformly distributed starting phase are used for scanning k-space along a sequence of circles tangent to the origin. Radial echo-planar imaging is known from JMR 135 (1998) 242-247.

Description of the invention. Embodiment. To the usual magnetic resonance pulse spectroscopy arrangement, which includes a main magnetic high field and its generator, an RF field and its generator with gated transmitter for RF-pulse generation, an RF receiver and signal recovery system, with a digital dual phase sensitive lock-in amplifier, with DSP (digital signal processing), familiar to people with ordinary skill in the present arts, a set of magnetic field gradient generators is added, capable of generating magnetic field gradients in three orthogonal x, y and z directions, where by convention the z-axis is taken in the direction of the main magnetic field. The magnetic field gradients. The following technical specification is required for the gradients: The x, y and z field gradients should be phase coherent. For the present description of the invention, where plane selective imaging will be described, this requirement should be satisfied between the field gradients along the x and y axes, so these gradients are in quadrature phase coherence, a situation familiar in the art for the lock-in amplifiers. It is obvious that for proper 3-D imaging (x,y,z)-phase coherence is required and is under control of the experimenter. The following technical specification should be mentioned for the gradients: the normal modes of the coil arrangements for the x, y and z gradients should be indicated by the manufacturer, and those frequencies should be avoided in the sequences of the experiments.

Imaging is done as follows. Preparation: The object to be imaged is placed on the object container. The container is placed in the main magnetic field. The standard procedure of 2-D imaging starts with a slice selection, in which an xy- plane perpendicular to the z-axis is selected with a slice-selective resonanceRF pulse in combination with a z-gradient. The magnetization in the selected xy-plane evolves in time and the FID (free induction decay) signal is observed. The invention is to observe, detect and processed the FID under the following actions: After slice selection the rotating field gradient is applied of the following form

$$Gx \ = \ \Delta \cos (\omega t + \varphi), \quad Gy \ = \ \Delta \sin (\omega t + \varphi) \qquad \qquad (1)$$

In equation (1) Gx and Gy are the field gradients in the x and y directions respectively, the constant $\Delta$ is the gradient field strength in angular frequency unit for the spins under consideration, the constant $\omega$ is angular frequency of the rotating field gradient; $\varphi$ is a phase angle representing the position of Gx and Gy at the chosen t = 0. Choosing the initial conditions $\varphi = 0$ for t = 0 means that Gx = $\Delta$ and Gy = 0, which specify the initial conditions and is therefore not arbitrary. For that reason the phase coherence as also the orthogonality of Gx and Gy should be specified technically, with the same rigor as has been done for the dual phase lock-in amplifier. In the present application where the rotation is used as an electronic turn table, the coherence is not necessary, under the approximations made. During data acquisition the gradient is put at maximum; between data acquisition the gradient can, but need not (for noise prevention), be switched off for cool down of the coils, to get higher maximum value for $\Delta$ and low duty cycle at non-resonant coil frequency or at random to disperse sound energy. The field gradients are thus rotated electronically and coherently with the constant rotation frequency $\omega$, which can be chosen at will.

The FID signal. Under the influence of the field gradients of equation (1), the free induction decay signal from a group of spins at location r with density d(r), in the resonance frame can be solved exactly. The solution serves for correct data acquisition in the general case depending on the sequence applied. As an example of practical interest a 2-D single shot high speed imaging is described. The multiple shot case, needed in cases of very rapid decay of the FID, is obvious from this example. The selected plane is scanned in successive time-intervals $\delta t$ (100 $\mu$s per orientation of $\omega$) and that part of the free induction decay is sampled rapidly and the data stored. Avoiding power line frequencies the period for the field gradient rotation can be of the order of 11 milliseconds (slow slew rate compared to gradient field strength). Up to a constant factor, the detected signal in the resonance frame can be written in complex notation, per $\delta t$, per orientation $\omega$:

$$S(r,t) = d(r) F(t) \exp(i \Phi), \quad \Phi = \Phi(r,t) \qquad (2)$$

$$\Phi = \Delta(r) \, t \, \text{sinc}(\omega t) \qquad (3)$$

where $\omega t \ll 1$ so that $\text{sinc}(\omega t)$ can be set equal to 1. $F(t)$ is a decaying function of $t$. It can be easily determined experimentally by switching off the field gradients; $\Delta$ is an angular frequency corresponding to the gradient strength at $r$. Relaxation, magnetic field inhomogeneity and local field interaction effects are all included in $F(t)$. The signal $S(r,t)$ is sampled at the sampling rate that is at least as required by Nyquist theorem for the highest value of $\Delta$ and the data stored in the DSP memory or transferred to a parallel processor (for off-line processing). Then the next orientation of $\omega$ is taken and data sampled and stored in the same manner. With the period of gradient rotation of 11 milliseconds (comparable to EPI [2]) data acquisition is accomplished in that order of time, in other word 2-D imaging can be achieved in 11 milliseconds.

Data processing. To obtain high resolution the sampled data are multiplied by the inverse of the experimentally obtainable $F(t)$. This should be obtained by the digital DSP to a good accuracy pertaining good signal to noise ratio. After this data manipulation the resulting signal, for a given orientation of $\omega$ of the gradient, has the form

$$S(r,t) = d(r) \exp(i \Delta t), \quad \Delta = \Delta(r) \qquad (4)$$

The main goal for this is high resolution. A gain in signal to noise of a factor of two is appreciated, but of insignificant importance by comparison. Spatial encoding along the gradient is obtained by FFT (Fast Fourier transform). The data of the other orientations are processed in the same way. Then one of the back projection algorithms [1], currently filtered back projection, can be used for a high resolution imaging.

In summary, a unification of the basic picture of Lauterbur [1] with the top-speed, but hardware demanding EPI of Mansfield [2] is achieved in a straightforward way with a new method of high speed, high resolution, silent real-time magnetic resonance imaging.

References to prior art

[1]. P. C. Lauterbur, Nature 242 (1973) 190-191: Image Formation by Induced Local Interactions: Examples Employing Nuclear Magnetic Resonance

[2]. P. Mansfield, J Physics C: Solid State Phys 10 (1977) L55-L58: Multiplanar image formation using spin echoes.

[3]. P. Mansfield, B. Haywood and R. Coxon, Magma 8 (1999)(Suppl 1) 55 and Magn Reson Med 46 (2001) 807-818: Active Acoustic Control in Gradient Coils for MRI.

[4]. D Tomasi and T Ernst, Brazilian Journal of Physics 36 (2006) 34-39: A Simple Theory for Vibration of MRI Gradient Coils.

[5]. Z H Cho, S T Chung, J Y Chung, S H Park, J S Kim, C H Moon and I K Hong, Magn Reson Med 39 (1998) 317-321. A new silent magnetic resonance imaging using a rotating DC gradient.

[6]. Z H Cho and W E Bunney Jr, Patent WO9812964 (1998-04-02): Apparatus and method for silent magnetic resonance imaging with rotating gradient coil.

[7]. F. Girard, V. L. Marcar, F. Hennel and E. Martin, Radiology 216 (2000) 900-902: Anatomic MR Images Obtained with Silent Sequences.

**Claims**

1. A high-speed magnetic resonance imaging method in which, during a single FID, only an electronically rotating magnetic field gradient of a maximum, constant strength is used for spatial encoding whereby, for each orientation of the gradient, a part of the FID-signal is rapidly sampled at a sampling rate that is at least as high as required by the Nyquist theorem for the highest local value of angular frequency corresponding to the gradient strength within the investigated object region, and the data thus obtained at each gradient orientation are Fourier transformed and then back-projected to obtain a high-resolution image.

2. The method of claim 1 in which, in order to obtain a high resolution, the sampled data are multiplied by the inverse of a decaying function F(t) which includes relaxation, magnetic field inhomogeneity and local field interaction effects.

3. The method of claim 1 or claim 2 in which the magnetic resonance is nuclear magnetic resonance or electron spin resonance.

4. The method of any one of the preceding claims in which the back-projection is filtered back-projection.

5. The method of any one of the preceding claims in which the sample is a liquid, a solid or a gas.

6. The method of any one of the preceding claims in which the imaging is two-, three- or higher-dimensional imaging.

7. Use of the method of any one of the preceding claims for the reduction of acoustic noise and/or the SAR and/or the EMF radiation level and/or for increasing throughput.

8. Use of the method of any one of claims 1-6 for magnetic resonance microscopy, for functional MRI, for velocimetry, for making a CINE or MRI-movie presentation, or for other real-time dynamical studies.

**Patentansprüche**

1. Ein schnelles Verfahren der bildgebenden magnetischen Resonanz, bei der, während eines einzigen freien Induktion Zerfall (FID), nur ein elektronisch rotierenden Magnetfeld Gradient von höchstens konstanter Stärke ist benutzt für räumliche Codierung wobei, für jede Orientierung des Gradient, ein Teil dem FID Signal ist aufgenommen, mit einer Aufname-Frequenz, mindestens so hoch wie benötigt von der Nyquist Theorem für den höchsten Wert der lokalen Winkelfrequenz entsprechend der Gradient Stärke innerhalb der untersuchten Objektregion, und die Daten somit bekommen bei jede Gradient Orientierung sind Fourier transformiert und dann zurück-projektiert um ein Bild mit hoher Auflösung zu erhalten.

2. Das Verfahren nach Anspruch 1 worin, um eine hohe Auflösung zu bekommen, die aufgenommen Daten sind multipliziert mit der Inverse von einer zerfallenden Funktion F(t) welche umfasst Effekte von Relaxation, Magnetfeld Inhomogenität und Lokal-Feld Interaktion.

3. Das Verfahren nach Anspruch 1 oder 2 worin die magnetische Resonanz ist Kemspin-Resonanz oder Elektronenspin-Resonanz.

4. Das Verfahren nach einem der vorangehenden Ansprüche worin die Zurück-Projektion ist Filterte Zurück-Projektion.

5. Das Verfahren nach einem der vorangehenden Ansprüche worin die Probe ist eine Flüssigkeit, ein Feststoff oder eines Gas.

6. Das Verfahren nach einem der vorangehenden Ansprüche worin die Tomografie ist zwei-, drei- oder höhere dimensionale Tomografie.

7. Anwendung dem Verfahren nach einem der vorangehenden Ansprüche zur Reduktion der akustischen Geräusche und/oder der SAR (spezifische Absorptionsrate) und/oder der EMF (Electromagnetischen Feld) Dosisleistung und/oder zur erhöhten Durchsatz.

8. Anwendung dem Verfahren nach einem der Ansprüche 1- 6 für MRM (Magnetresonanz-Mikroskopie), für funktionelle MRT (Magnetresonanz-Tomografie), für Geschwindigkeit Messungen, für eine CINE - oder MRT-Film Präsentation, oder für andere in Echtzeit dynamische Studien.

## Revendications

**1.** Une méthode d'imagerie de résonance magnétique rapide dans laquelle, pendant un seul FID (decay d'induction libre), seulement un gradient de champ magnétique d'une force au maximum et constante, tournant électroniquement, est utilisé pour encoder spatial qui prévoit que, pour chaque orientation du gradient, une partie du FID signal est rapidement essayée à un taux d'échantillonnage qui est au mois aussi haut qu'exigé par le théorème de Nyquist pour la valeur plus haute de fréquence angulaire locale correspondée à la force de gradient dans la région d'objet examinée, et les données ont obtenu ainsi à chaque orientation de gradient sont Fourier transformées et alors sumis à l'arrière-projection pour obtenir une image d'haute résolution.

**2.** La méthode de revendication 1 dans laquelle, pour obtenir une haute résolution, les données essayées sont multipliées par l'inverse d'une decay-function F(t) qui inclut les effets de relaxation, de inhomogénéité de champ magnétique et des interactions de champs locaux.

**3.** La méthode de revendication 1 ou 2 dans laquelle la résonance magnétique est la résonance magnétique nucléaire ou la résonance de spin électronique.

**4.** La méthode de n'importe quelle une des revendications précédentes dans laquelle l'amère-projection est l'amère-projection filtrée.

**5.** La méthode de n'importe quelle une des revendications précédentes dans laquelle l'échantillon est un liquide, un solide ou un gaz.

**6.** La méthode de n'importe quelle une des revendications précédentes dans laquelle l'imagerie est l'imagerie deux-, tri- ou plus dimensionnelle.

**7.** L'usage de la méthode de n'importe quelle une des revendications précédentes pour la réduction de bruit acoustique et/ou de taux d'absorption spécifique et/ou de niveau de rayonnement de champ électromagnétique et/ou pour augmenter de capacité de traitement.

**8.** L'usage de la méthode de n'importe quelle une des revendications 1- 6 pour la microscopie de résonance magnétique, pour l'IRM (imagerie de résonance magnétique) fonctionelle, pour velocimetry, pour faire cinématographique ou la présentation d'IRM-Film, ou pour les autres études dynamiques en temps réel.

**EP 1 995 604 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4727825 A
- EP 0256779 A

- WO 9812964 A

**Non-patent literature cited in the description**

- *JMR,* 1989, vol. 82, 337-341
- *JMR,* 1998, vol. 135, 242-247
- **P. C. Lauterbur.** Image Formation by Induced Local Interactions: Examples Employing Nuclear Magnetic Resonance. *Nature,* 1973, vol. 242, 190-191
- **P. Mansfield.** Multiplanar image formation using spin echoes. *J Physics C: Solid State Phys,* 1977, vol. 10, L55-L58
- **P. Mansfield ; B. Haywood ; R. Coxon.** *Magma,* 1999, vol. 8 (1), 55
- ctive Acoustic Control in Gradient Coils for MRI. *Magn Reson Med,* 2001, vol. 46, 807-818

- **D Tomasi ; T Ernst.** A Simple Theory for Vibration of MRI Gradient Coils. *Brazilian Journal of Physics,* 2006, vol. 36, 34-39
- **Z H Cho ; S T Chung ; J Y Chung ; S H Park ; J S Kim ; C H Moon ; I K Hong.** A new silent magnetic resonance imaging using a rotating DC gradient. *Magn Reson Med,* 1998, vol. 39, 317-321
- **F. Girard ; V. L. Marcar ; F. Hennel ; E. Martin.** Anatomic MR Images Obtained with Silent Sequences. *Radiology,* 2000, vol. 216, 900-902